(19) Europäisches Patentamt
European Patent Office
Office européen des brevets

(11) **EP 2 466 703 B1**

(12) **FASCICULE DE BREVET EUROPEEN**

(45) Date de publication et mention de la délivrance du brevet:
**27.02.2019 Bulletin 2019/09**

(51) Int Cl.:
*H01S 3/042* *(2006.01)*    *H01S 3/06* *(2006.01)*

(21) Numéro de dépôt: **11193845.2**

(22) Date de dépôt: **15.12.2011**

(54) **Dispositif d'émission d'un faisceau laser anti lasage transverse et à refroidissement longitudinal**

Vorrichtung zum Aussenden von Laserstrahlenbündeln zum transversalen Antilasern und zur Längsabkühlung

Device for emitting a laser beam with anti-transverse lasing and with longitudinal cooling

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2010 FR 1004945**

(43) Date de publication de la demande:
**20.06.2012 Bulletin 2012/25**

(73) Titulaire: **THALES**
**92400 Courbevoie (FR)**

(72) Inventeur: **Branly, Stéphane**
**91150 Brieres-les-Scelles (FR)**

(74) Mandataire: **Henriot, Marie-Pierre et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**FR-A1- 2 877 776    FR-A1- 2 901 067**
**US-A- 3 631 362    US-A1- 2005 058 173**

• **VETROVEC J: "DIODE-PUMPED ACTIVE MIRROR AMPLIFIER FOR HIGH-AVERAGE POWER", PROCEEDINGS OF THE INTERNATIONAL CONFERENCE ON LASERS, XX, XX, 4 décembre 2000 (2000-12-04), pages 776-783, XP008006316, & US 4 225 826 A (LEWIS OWEN ET AL) 30 septembre 1980 (1980-09-30)**
• **GUCH S: "PARASITIC SUPPRESSION IN LARGE APERTURE DISK LASERS EMPLOYING LIQUID EDGE CLADDINGS", APPLIED OPTICS, OPTICAL SOCIETY OF AMERICA, US, vol. 15, no. 6, 1 juin 1976 (1976-06-01), pages 1453-1457, XP002419100, ISSN: 0003-6935, DOI: DOI:10.1364/AO.15.001453**
• **KELLY J H ET AL: "HIGH-REPETITION-RATE CR:ND:GSGG ACTIVE-MIRROR AMPLIFIER", OPTICS LETTERS, OSA, OPTICAL SOCIETY OF AMERICA, WASHINGTON, DC, US, vol. 12, no. 12, 1 décembre 1987 (1987-12-01), pages 996-998, XP002069938, ISSN: 0146-9592, DOI: DOI:10.1364/OL.12.000996**

## Description

Le domaine de l'invention est celui des lasers à solide, notamment celui des lasers impulsionnels à impulsions brèves (nanosecondes à femtosecondes) de haute énergie par impulsion (supérieure à 10 J) et de haute puissance moyenne (supérieure à 10 W).

On rappelle brièvement le fonctionnement d'un dispositif d'émission d'un faisceau laser. Il comprend principalement un milieu amplificateur et des sources de pompage qui injectent de l'énergie dans le milieu amplificateur. Ce milieu amplificateur qui a la forme d'un barreau peut être un cristal, ou encore un verre dopé. Ensuite, le faisceau laser à amplifier traverse le barreau amplificateur une ou plusieurs fois au moyen de dispositifs optiques à miroirs par exemple ; à chaque passage il extrait une partie de l'énergie injectée lors du pompage et est ainsi amplifié dans le barreau amplificateur. Pour un barreau amplificateur de forme cylindrique, l'énergie déposée lors du pompage est généralement confinée dans la partie du barreau amplificateur, délimitée par le diamètre du faisceau de pompe.

Sur ce type de configuration de dispositif d'amplification de faisceau laser, un phénomène parasite appelé lasage transverse apparaît entre le moment du dépôt d'énergie dans le barreau amplificateur par pompage optique et celui de son extraction par le faisceau à amplifier.

Ce phénomène est lié à la création dans le barreau amplificateur d'une sous-cavité laser selon un axe transversal à l'axe longitudinal du barreau amplificateur, les ruptures d'indice de réfraction à l'interface barreau amplificateur-environnement assurant la fonction de miroirs de cette sous-cavité. Le lasage transverse s'établit lorsque la condition d'oscillation de cette sous-cavité est satisfaite, c'est-à-dire lorsqu'il y a conservation de l'énergie sur un aller-retour au sein de la sous-cavité, ou dit autrement lorsque le gain transverse G compense les pertes P de la sous-cavité.

Dans la suite on prend comme exemple de barreau amplificateur, un cristal ; on peut bien sûr le remplacer par du verre dopé.

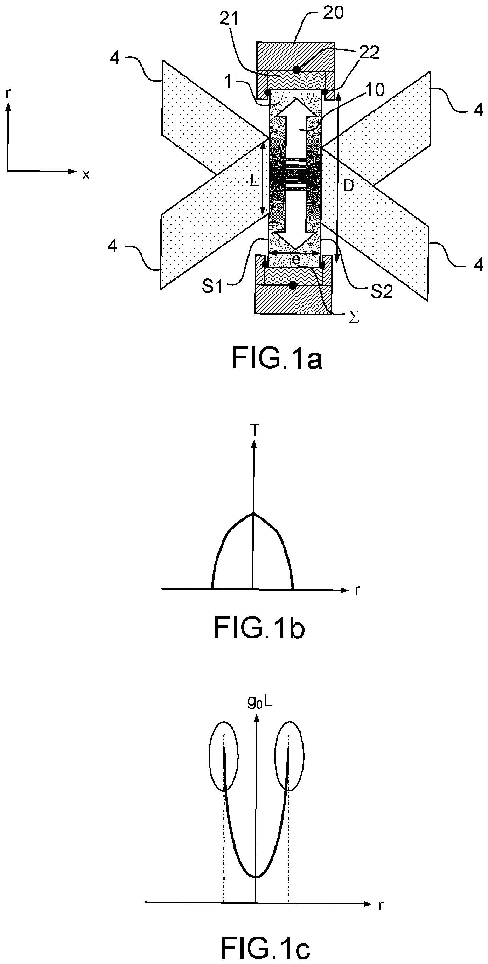

On a représenté figure 1c le gain optique G transverse dans un cristal amplificateur 1 cylindrique (fig 1a) de longueur e, pompé par ses deux faces S1, S2 par un faisceau laser de pompage 4 de diamètre L. Si l'on désigne $g_0$ la densité linéique de gain, le gain petit signal $g_{ps}$ est égal à g0 x e dans la direction longitudinale Ox et à g0 x L dans une direction transverse perpendiculaire à Ox. On a couramment L≥e.

Le gain optique G étant proportionnel à $e^{g_{ps}}$, on a :

$$e^{g0 \cdot L} >> e^{g0 \cdot e}$$

Le gain optique G dans la direction transverse est donc beaucoup plus grand que le gain optique G dans la direction longitudinale, c'est-à-dire dans la direction du faisceau laser à amplifier.

Le lasage transverse se manifeste par un vidage brutal de l'énergie stockée dans le cristal, provoqué par des émissions stimulées transverses non contrôlées, au dépend du faisceau laser que l'on veut amplifier.

Ce lasage transverse est particulièrement gênant dans le cas de milieux amplificateurs solides à forts gains et de grandes dimensions (typiquement un gain g0 de 0.88 et un diamètre de pompe de 70mm). Il empêche par exemple de générer des impulsions laser femto secondes de puissance très importante, typiquement de l'ordre du petawatt, à partir d'un cristal Ti : Saphir pompé à de fortes énergies de l'ordre de 100 J.

Jusqu'à aujourd'hui, il y a deux grands types de solutions pour supprimer ce lasage transverse, celles qui consistent à réduire le gain pour le faisceau parasite et celles qui consistent à augmenter les pertes pour le faisceau parasite.

Les premières sont peu utilisées et peu appréciées car le problème est que réduire le gain pour le faisceau parasite consiste aussi à réduire le gain pour le faisceau principal. Une solution élégante a été proposée par la demanderesse, qui consiste à partir de l'énergie de pompage disponible, à la morceler et à l'envoyer au matériau pompé à des instants différents. Cette solution a fait l'objet de la demande de brevet Français n° 0413734 « Dispositif électronique de suppression du lasage transverse dans les amplificateurs laser haute énergie ».

La plupart des solutions reposent cependant sur l'augmentation du niveau de pertes pour les oscillations parasites.

Une première possibilité est de remplacer l'air par de l'eau autour de la surface $\Sigma$ reliant les faces S1 et S2 du cristal 1, ce qui a pour avantage de diminuer le coefficient de réflexion à l'interface (on passe de 1 à 1,33 tandis que le matériau a en général un indice de réfraction compris entre 1,5 et 1,8) et d'améliorer le refroidissement du cristal dans une zone où il y a un dépôt de chaleur important. Cette solution a fait l'objet de la demande de brevet Français n° 04411815. Cependant, cette solution n'est pas entièrement satisfaisante car le coefficient de réflexion à l'interface est encore trop élevé et de plus le rayonnement à 800 nm peut être réfléchi par la monture mécanique et renvoyé vers le matériau.

Les solutions utilisées actuellement consistent en fait à remplacer l'eau par un liquide dont l'indice de réfraction est identique ou extrêmement proche de celui du matériau (on parle alors d'adaptation d'indice) et d'ajouter à ce liquide d'adaptation d'indice 21 un matériau qui absorbe le rayonnement à 800 nm : ce matériau absorbeur est également à l'état liquide (il s'agit en général d'un colorant) et est mélangé au liquide d'adaptation d'indice. Ainsi, les photons amplifiés à 800 nm perpendiculairement à l'axe, ne sont pas réfléchis à l'interface avec le matériau grâce au liquide d'adaptation d'indice (donc ne peuvent traverser une deuxième fois la zone de gain pour être amplifiés davantage encore) puis sont absorbés par le colorant. Cette technique décrite dans la demande de brevet FR 2 901 067 fonctionne bien pour éliminer les oscillations transverses pour les chaînes laser à base de Saphir dopé Titane car du fait du faible taux de répétition des lasers de pompage (au maximum 0,1 Hz), la charge thermique dans les cristaux de Saphir dopé Titane était limitée (au maximum 100 J de pompage à 0,1 Hz produisant une charge thermique de 6 à 7 W compte-tenu du rendement d'amplification) et des architectures avec un mélange liquide d'indice + colorant non circulant autour du cristal de Saphir Titane pouvaient parfaitement répondre au besoin.

Mais la technologie des lasers de pompage a sensiblement évolué ces dernières années et il devient désormais possible de disposer d'une centaine de Joule à un taux de répétition compris entre 1 et 5 Hz, et dans un avenir très proche 10 Hz pourront être atteints ce qui donnera une puissance moyenne de pompage de l'ordre du kiloWatt et un dépôt thermique dans le cristal de l'ordre de 600 à 700 Watt.

A ce stade, il n'est pas efficace de mettre en oeuvre une évacuation radiale de la chaleur (représentée par la flèche 10) par le mélange liquide d'indice + colorant dont la capacité calorifique est très en-deçà de celle de l'eau. Les propriétés thermiques du mélange utilisé (liquide d'indice pour assurer l'adaptation d'indice et colorant absorbant l'émission laser parasite) ne permettent pas une évacuation satisfaisante de la chaleur. En effet, le liquide d'adaptation d'indice est un mauvais conducteur thermique ce qui se traduit lors d'une montée en cadence des lasers par un profil de température parabolique illustré figure 1b dégradant le Rapport de Strehl (qui est un coefficient de qualité du faisceau) et induisant une courte focale thermique et des aberrations de front d'onde.

Une solution consiste à remplacer le liquide d'adaptation d'indice par un doigt froid en contact métallique avec la surface Σ du cristal. Cela permet de réduire les effets thermiques mais pas de manière satisfaisante dès que la puissance moyenne dépasse 400 W. En outre un tel dispositif cryogénique est lourd, cher, sujet à vibrations et ne permet pas de supprimer le lasage transverse.

Il existe aussi actuellement des dispositifs d'émission d'un faisceau laser qui comportent un milieu amplificateur sous forme de plaque solide avec pompage et extraction thermique dans l'axe longitudinal et qui comportent sur la tranche (la surface Σ) un matériau solide différent qui remplit les fonctions d'adaptation d'indice et d'absorbeur ; le matériau est soit "soudé" au matériau amplificateur soit placé en contact par adhérence moléculaire. Mais ces bordures ou couronnes ne sont pas toujours réalisables technologiquement en fonction des matériaux.

En conséquence, il demeure à ce jour un besoin pour un dispositif d'émission d'un faisceau laser donnant simultanément satisfaction à l'ensemble des exigences précitées, en termes notamment de suppression du lasage transverse, de refroidissement et de simplicité d'utilisation.

L'invention est basée sur un refroidissement longitudinal compatible de l'utilisation d'un liquide d'adaptation d'indice pour supprimer le lasage transverse. Un exemple d'un tel refroidissement longitudinal est décrit dans la publication « Diode-pumped active mirror amplifier for high-average power » de Vetrovec J. et le brevet US 4 225 826, mais le dispositif décrit ne permet pas de supprimer le lasage transverse tout en assurant le refroidissement, de manière satisfaisante.

Plus précisément l'invention a pour objet un dispositif d'émission d'un faisceau laser qui comprend un milieu amplificateur solide cylindrique, de longueur d'onde de fluorescence λ, délimité par une surface Σ reliant deux faces S1 et S2, destiné à être pompé par les deux faces ou l'une d'elles pour devenir un milieu à gain. Il est principalement caractérisé en ce qu'il comprend un fluide de refroidissement de conductivité thermique Cr en contact avec le milieu amplificateur selon l'une des faces, et un liquide d'adaptation d'indice absorbant ou diffusant à la longueur d'onde de fluorescence, de conductivité thermique $Ci < 0.3\, Cr$, en contact avec le milieu amplificateur selon sa surface Σ.

Un des avantages de ce dispositif est que le gradient thermique (dans l'hypothèse d'un dépôt de chaleur à peu près uniforme dans le matériau) est important selon l'axe de propagation Ox et faible perpendiculairement à l'axe contrairement au cas du refroidissement radial. Les effets de lentille thermique sont donc fortement réduits et la qualité du front d'onde est ainsi améliorée et à peu près indépendante du niveau de puissance de pompage.

Et l'utilisation d'un liquide pour supprimer le lasage transverse offre une solution astucieuse et universelle en ce sens qu'il est très facile d'adapter le liquide 21 (en changeant le colorant par exemple) au milieu amplificateur 1 choisi, contrairement à la solution de l'art antérieur avec une couronne solide soudée au milieu amplificateur.

De préférence, la face du milieu amplificateur en contact avec le fluide de refroidissement comporte un traitement réfléchissant à la longueur d'onde λ, destiné à réfléchir le faisceau laser vers le milieu amplificateur.

Lorsque le milieu amplificateur est destiné à être pompé par les deux faces, le traitement réfléchissant à la longueur d'onde λ, est transparent à la longueur d'onde de pompage.

Il comprend éventuellement aussi un fluide de refroidissement de conductivité thermique Cr en contact avec l'autre face.

Le fluide de refroidissement est par exemple de l'eau ou de l'Hélium et le milieu amplificateur un cristal Ti : Sa.

Selon un mode d'exploitation particulier, il comporte en aval du liquide de refroidissement, un élément de correction de phase du faisceau émis.

Ce dispositif d'émission d'un faisceau laser peut être utilisé comme oscillateur laser ou comme amplificateur laser.

D'autres caractéristiques et avantages de l'invention apparaîtront à la lecture de la description détaillée qui suit, faite à titre d'exemple non limitatif et en référence aux dessins annexés dans lesquels :

les figures 1 déjà décrites représentent schématiquement un exemple de dispositif d'amplification d'un faisceau laser équipé d'un dispositif de suppression du lasage transverse et à refroidissement radial (fig 1a), le profil de température associé en fonction du rayon r du barreau (fig 1b), ainsi que le gain transverse (fig 1c), selon l'état de la technique,

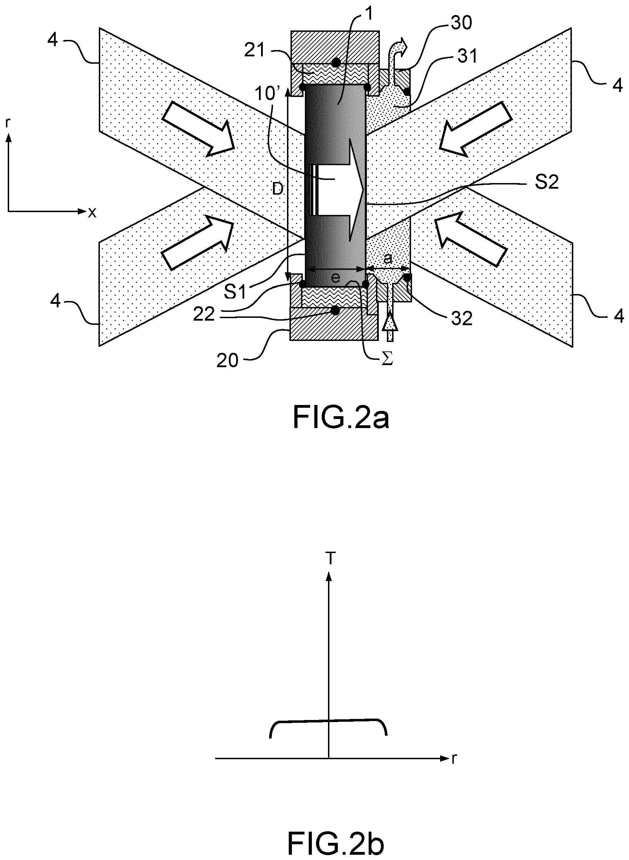

les figures 2 représentent schématiquement un exemple de dispositif d'amplification d'un faisceau laser équipé d'un dispositif de suppression du lasage transverse et à refroidissement longitudinal (fig 2a) et le profil de température associé en fonction du rayon r du barreau (fig 2b), selon l'invention.

D'une figure à l'autre, les mêmes éléments sont repérés par les mêmes références.

Dans la suite on va prendre comme exemple de milieu amplificateur 1 un barreau de cristal à faces S1, S2 circulaires de diamètre D. Les cristaux envisagés sont aussi bien des monocristaux que des céramiques poly-cristallines.

Un dispositif d'amplification d'un faisceau laser selon l'invention, décrit en relation avec les figures 2, est principalement doté :

- d'un dispositif 20 destiné à combattre les oscillations parasites transverses, et placé de sorte qu'un liquide d'adaptation d'indice 21 absorbant ou diffusant à la longueur d'onde de fluorescence, soit en contact avec la surface Σ du cristal 1,
- d'un dispositif 30 de circulation d'un fluide de refroidissement 31 positionné de sorte que le fluide de refroidissement 31 soit en contact avec une surface S1 ou S2 du cristal 1 (la surface S2 sur la figure).

Le dispositif de refroidissement 30 est conçu de préférence de manière à pouvoir laisser traverser le rayonnement de pompage 4 ; le milieu amplificateur peut donc être pompé par les deux faces S1 et S2.

Sur la totalité de la longueur e du cristal, le mélange liquide d'indice 21 + colorant est en contact avec la surface Σ du cristal 1 et permet donc d'assurer la fonction de suppression des oscillations transverses. Il est maintenu en contact avec le cristal au moyen d'une pièce mécanique équipée de joints d'étanchéité 22, connue de l'homme du métier.

On ajoute une circulation indépendante d'un fluide 31 qui va être en contact avec une face S2 du cristal 1 (de préférence toute la surface S2) et va évacuer la chaleur générée dans le cristal 1 par le rayonnement de pompage 4. Ce fluide de refroidissement 31 est maintenu en contact avec le cristal 1 au moyen d'une pièce mécanique 30 également équipée de joints d'étanchéité 32, et permettant la circulation de ce fluide le long de la surface S2. Ces pièces 20 et 30 sont disposées de manière à ce que le liquide d'adaptation d'indice 21 et le fluide de refroidissement 31 ne soient pas en contact.

Pour que l'évacuation de la thermique (représentée par la flèche 10') soit essentiellement longitudinale (selon Ox) empêchant l'apparition de tout gradient de température et donc d'indice transverse (selon r), et évitant ainsi l'apparition d'une lentille thermique dans le milieu amplificateur, on utilise un liquide d'adaptation d'indice dont la conductivité thermique Ci est inférieure à celle Cr du fluide de refroidissement avec Ci < 0.3 Cr.

En utilisant par exemple du diiodométhane de conductivité thermique Ci égale à 0.1 W/(m.K) comme liquide d'adaptation d'indice 21 et de l'eau de conductivité thermique Cr égale à 0.6 W/(m.K) comme fluide de refroidissement 31, il n'y a quasiment pas d'apparition de lentille thermique dans un cristal de Ti:Sa comme on peut le voir figure 2b.

Ce découplage entre la fonction anti-lasage transverse et la fonction refroidissement permet ainsi d'évacuer des quantités de chaleur importantes compte-tenu des constantes thermiques de l'eau. L'évacuation de la chaleur est d'autant plus efficace que le milieu amplificateur n'est pas trop épais : on a de préférence e<D/2, D étant le diamètre du milieu amplificateur. Et l'utilisation d'un liquide pour supprimer le lasage transverse offre une solution universelle en ce sens qu'il est très facile d'adapter le liquide 21 au milieu amplificateur 1 choisi, contrairement à la solution de l'art antérieur avec une couronne solide soudée au milieu amplificateur.

Un autre avantage très important est que le gradient thermique (dans l'hypothèse d'un dépôt de chaleur à peu près uniforme dans le matériau) est important selon l'axe de propagation Ox et faible perpendiculairement à l'axe contrairement au cas du refroidissement radial. Les effets de lentille thermique sont donc fortement réduits et la qualité du front d'onde est ainsi améliorée et à peu près indépendante du niveau de puissance de pompage.

Dans une configuration de base, le milieu amplificateur 1 est pompé par les deux faces S1 et S2 ce qui est important pour uniformiser le dépôt de chaleur, alors que le faisceau laser est réfléchi par la surface S2 du milieu amplificateur en contact avec le fluide de refroidissement 31. En effet, on peut considérer en première analyse que le faisceau de pompage 4 peut traverser la lame d'eau sans difficultés car il n'est pas absorbé (l'eau est transparente dans une bonne partie du spectre visible et proche infrarouge) et même si le front d'onde est légèrement perturbé à la traversée de l'eau, cela est sans conséquences car le processus de pompage consiste en un transfert d'énergie suite à l'absorption du rayonnement et ce rayonnement est absorbé suffisamment rapidement pour qu'il n'y ait pas de risques de dégradation du faisceau de pompe conduisant par exemple à des surintensités susceptibles d'endommager le milieu amplificateur. En revanche, dans cette configuration de base, le faisceau à amplifier est réfléchi à l'interface milieu amplificateur-eau (surface S2) afin de ne pas avoir à traverser la lame d'eau qui est susceptible de dégrader le front d'onde ; à cet effet la face S2 (dite face arrière) du milieu amplificateur est traitée avec une haute réflectivité (on a typiquement R > 98%) pour la longueur d'onde de fluorescence du milieu amplificateur mais avec une bonne transparence (on a typiquement T> 95%) pour la longueur d'onde du faisceau de pompage 4.

Lorsque le milieu amplificateur 1 n'est pompé que par la face S1, la condition de transparence (du traitement réfléchissant) de la face S2 pour la longueur d'onde du faisceau de pompage 4 n'est plus nécessaire.

Le fait d'avoir la face S2 du matériau traitée avec une haute réflectivité pour la longueur d'onde à amplifier risque de favoriser une oscillation parasite longitudinale (entre les 2 faces S1 et S2 du milieu amplificateur) car même si le gain dans l'axe est plus faible, c'est la face S1 (dite face avant) qui à elle seule doit, grâce à son traitement anti-reflets, contrecarrer le gain, or il est connu qu'un traitement anti-reflets bi-bande (une bande pour le laser, une bande pour le pompage) dont une bande large et qui doit être résistant au flux laser n'est pas extrêmement performant en termes de réflectivité résiduelle.

C'est pourquoi, selon une première variante de configuration, le faisceau à amplifier traverse la lame d'eau et peut être corrigé si nécessaire en front d'onde au moyen d'un composant de correction de la phase, par exemple un miroir déformable disposé en dehors du cristal, en aval de la lame d'eau, sur le trajet du faisceau laser émis.

Selon une deuxième variante, un deuxième dispositif de refroidissement est ajouté sur l'autre face du milieu amplificateur, la face S1.

Quelle que soit la configuration choisie, l'eau peut être remplacée par un autre liquide tel que l'éthylène, ou l'éthylène-glycol ou un mélange eau + éthylène-glycol par exemple ou encore par un flux de gaz (par exemple de l'Hélium) optimisé pour assurer un bon échange thermique. Un flux de gaz est particulièrement bien adapté aux variantes de configuration car il conduit à des perturbations moindres du front d'onde que la traversée d'une lame d'eau, notamment si l'écoulement est turbulent.

On va à présent décrire un exemple de réalisation avec de l'eau comme fluide de refroidissement, et un cristal de Ti :Sa comme milieu amplificateur avec des surfaces circulaires S1 et S2 de 20 cm de diamètre.

On note :

F = débit d'eau en l/min.
p= masse volumique de l'eau = 1000kg/m3
Cp = capacité calorifique de l'eau = 4180 J/(kg.°C)
$\Delta T$ = élévation de température en °C de l'eau de refroidissement

V = vitesse d'écoulement de l'eau en m/s
S = section du filet d'eau en m² = a x D
P = puissance thermique à extraire du Ti:Sa en W

On a :

$$P(W) = F \times (1/60000) \times \rho \times Cp \times \Delta T$$

Avec

$$F \ (l/min) = V \times S \times 60000$$

Pour :
P à évacuer = 1 kW ; a = 5mm ; D = 20 cm ; $\Delta T$ = 1°C, il faut donc avoir un débit : F = 14,35 l/min soit 0,24 m/s (ou 0,8 km/h).

Dit autrement, si on refroidit la face arrière (S2) d'un Ti:Sa de 20 cm de diamètre avec un film d'eau de 5mm d'épaisseur de débit égal à 14.4 l/min, alors on sait extraire 1 kW de thermique (soit l'étage amplificateur principal d'un système laser 10 PW à 2 Hz) pour une augmentation de la température d'eau de seulement 1°C.

Cette configuration présente les avantages suivants :

- l'absence de lentille thermique permet de modifier l'énergie de pompage sans modifier les conditions de propagation du faisceau à 800nm (= longueur d'onde de fluorescence du Ti :Sa),
- des puissances moyennes de pompage supérieures au kW sont possibles,
- la face S2 du cristal de Ti:Sa en contact avec l'eau est traitée réfléchissante à 800nm. Ainsi le faisceau à 800nm ne traverse pas la pellicule d'eau, ce qui permet d'éviter la dégradation du front d'onde,
- des gains transverses exp(g0 x L) jusqu'à 20000 sont atteignables sans lasage transverse, ce qui permet d'atteindre des puissances crêtes de 10PW (300J sortie d'ampli sur diamètre 17 cm avec 800J de pompe).

A titre d'autre exemple de milieu amplificateur, on peut citer : Nd : YAG, Nd :YLF, Yb : YAG, etc.

On a présenté un exemple de dispositif d'amplification d'un faisceau laser émis par un oscillateur, mais le dispositif selon l'invention peut aussi être utilisé dans un oscillateur laser générant un faisceau laser.

## Revendications

1. Dispositif d'émission d'un faisceau laser qui comprend :

   - un milieu amplificateur solide (1) cylindrique, de longueur d'onde de fluorescence λ, délimité par une surface Σ reliant deux faces S1 et S2, destiné à être pompé par les deux faces ou l'une d'elles pour devenir un milieu à gain,

- un fluide de refroidissement (31) de conductivité thermique Cr en contact avec le milieu amplificateur (1) selon l'une des faces, et

- un liquide d'adaptation d'indice (21) absorbant ou diffusant à la longueur d'onde de fluorescence, de conductivité thermique Ci, en contact avec le milieu amplificateur (1) selon sa surface Σ,

**caractérisé en ce que** Ci < 0.3 Cr.

2. Dispositif d'émission d'un faisceau laser selon la revendication précédente, **caractérisé en ce que** la face du milieu amplificateur (1) en contact avec le fluide de refroidissement (31) comporte un traitement réfléchissant à la longueur d'onde λ, destiné à réfléchir le faisceau laser vers le milieu amplificateur.

3. Dispositif d'émission d'un faisceau laser selon la revendication précédente, **caractérisé en ce que** le traitement réfléchissant à la longueur d'onde λ, est transparent à la longueur d'onde de pompage.

4. Dispositif d'émission d'un faisceau laser selon l'une des revendications précédentes, **caractérisé en ce qu'**il comprend un fluide de refroidissement de conductivité thermique Cr en contact avec l'autre face.

5. Dispositif d'émission d'un faisceau laser selon l'une des revendications précédentes, **caractérisé en ce qu'**il comporte sur le trajet de sortie du faisceau émis, en aval du fluide de refroidissement, un élément de correction de phase.

6. Dispositif d'émission d'un faisceau laser selon l'une des revendications précédentes, **caractérisé en ce que** le fluide de refroidissement est de l'eau ou de l'Hélium et **en ce que** le milieu amplificateur est un cristal Ti :Sa.

7. Dispositif d'émission d'un faisceau laser selon l'une des revendications précédentes, qui est un oscillateur laser ou un amplificateur laser.

**Patentansprüche**

1. Vorrichtung zum Aussenden eines Laserstrahls, welches Folgendes beinhaltet:

- ein zylindrisches, festes Verstärkermedium (1) mit Fluoreszenz-Wellenlänge λ, begrenzt durch eine Oberfläche Σ, welche zwei Seiten S1 und S2 verbindet, dazu bestimmt, durch beide Seiten gepumpt zu werden, oder durch eine davon, um ein Verstärkungsmedium zu werden,

- ein Kühlfluid (31) mit thermischer Leitfähigkeit Cr in Kontakt mit dem Verstärkermedium (1) entlang einer der Seiten, und

- eine Indexanpassungsflüssigkeit (21), welche bei der Fluoreszenz-Wellenlänge absorbiert oder streut, mit thermischer Leitfähigkeit Ci, in Kontakt mit dem Verstärkermedium (1) entlang dessen Oberfläche Σ,

**dadurch gekennzeichnet, dass** Ci < 0,3 Cr beträgt.

2. Vorrichtung zum Aussenden eines Laserstrahls nach dem vorhergehenden Anspruch, **dadurch gekennzeichnet, dass** die Seite des Verstärkermediums (1) in Kontakt mit dem Kühlfluid (31) eine bei der Wellenlänge λ reflektierende Behandlung beinhaltet, welche dazu bestimmt ist, den Lasterstrahl zum Verstärkermedium zu reflektieren.

3. Vorrichtung zum Aussenden eines Laserstrahls nach dem vorhergehenden Anspruch, **dadurch gekennzeichnet, dass** die bei der Wellenlänge λ reflektierende Behandlung bei der Pumpwellenlänge transparent ist.

4. Vorrichtung zum Aussenden eines Laserstrahls nach einem der vorhergehenden Ansprüche, **dadurch gekennzeichnet, dass** sie ein Kühlfluid mit thermischer Leitfähigkeit Cr in Kontakt mit der anderen Seite beinhaltet.

5. Vorrichtung zum Aussenden eines Laserstrahls nach einem der vorhergehenden Ansprüche, **dadurch gekennzeichnet, dass** sie auf dem Austritts-Strahlengang des ausgesendeten Strahls im nachgelagerten Bereich des Kühlfluids ein Phasenkorrekturelement beinhaltet.

6. Vorrichtung zum Aussenden eines Laserstrahls nach einem der vorhergehenden Ansprüche, **dadurch gekennzeichnet, dass** das Kühlfluid Wasser oder Helium ist und dadurch, dass das Verstärkermedium ein Ti:Sa-Kristall ist.

7. Vorrichtung zum Aussenden eines Laserstrahls nach einem der vorhergehenden Ansprüche, welche ein Laser-Oszillator oder ein Laser-Verstärker ist.

**Claims**

1. A device for emitting a laser beam, which comprises:

- a cylindrical solid amplifier medium (1), having a fluorescence wavelength λ, delimited by a surface Σ connecting two faces S1 and S2 and intended to be pumped through both the faces, or one of them, in order to become a gain medium,
- a cooling fluid (31) of thermal conductivity Cr in contact with the amplifier medium (1) over one of the faces and
- an index matching liquid (21) that absorbs or scatters at the fluorescence wavelength, of thermal conductivity Ci, in contact with the amplifier medium (1) over its surface $\Sigma$,

**characterised in that** Ci < 0.3 Cr.

2. The device for emitting a laser beam according to the preceding claim, **characterised in that** the face of the amplifier medium (1) in contact with the cooling fluid (31) is provided with a treatment reflective at the wavelength $\lambda$, which is intended to reflect the laser beam toward the amplifier medium.

3. The device for emitting a laser beam according to the preceding claim, **characterised in that** the treatment reflective at the wavelength $\lambda$ is transparent at the pumping wavelength.

4. The device for emitting a laser beam according to one of the preceding claims, **characterised in that** it comprises a cooling fluid of thermal conductivity Cr in contact with the other face.

5. The device for emitting a laser beam according to one of the preceding claims, **characterised in that** it comprises a phase correction element on the output path of the emitted beam, downstream of the cooling fluid.

6. The device for emitting a laser beam according to one of the preceding claims, **characterised in that** the cooling fluid is water or helium and **in that** the amplifier medium is a Ti:Sa crystal.

7. The device for emitting a laser beam according to one of the preceding claims, which is a laser oscillator or a laser amplifier.

FIG.1a

FIG.1b

FIG.1c

## FIG.2a

## FIG.2b

**EP 2 466 703 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 0413734
- FR 04411815

- FR 2901067
- US 4225826 A